# EUROPEAN PATENT APPLICATION

(11) **EP 4 468 838 A1**
(43) Date of publication of application: **27.11.2024**
(21) Application number: 23174739.5
(22) Date of filing: 23.05.2023
(51) Int. Cl.: H10B 12/00, H01L 29/786

(54) **A VERTICAL OXIDE-SEMICONDUCTOR BASED TRANSISTOR ARRAY WITH ISOLATED CHANNELS**

(71) Applicant: Imec VZW, 3001 Leuven (BE); Huawei Technologies Co., Ltd., Shenzhen, Guangdong 518129 (CN)
(72) Inventor: BANERJEE, Kaustuv, 3001 Heverlee (BE); KAR, Gouri Sankar, 3001 Leuven (BE); HUANG, Kailiang, Shenzhen, 518129 (CN); FENG, Junxiao, Shenzhen, 518129 (CN); LEONELLI, Daniele, 3000 Leuven (BE); JING, Weiliang, Shanghai, 201206 (CN); SHENG, Jiazhen, Shanghai, 201206 (CN)
(74) Representative: Roth, Sebastian

(57) **Abstract**

This disclosure relates to a transistor array for dynamic random access memory (DRAM). The disclosure particularly presents a vertical oxide-semiconductor based transistor array. The transistor array comprises a substrate layer, and a plurality of vertical transistors formed above the substrate. Each vertical transistor comprises a first contact and a second contact, which are arranged one above the other at different distances from a surface of the substrate layer, and a transistor channel that connects the first and the second contact. Each transistor channel comprises an oxide-semiconductor material, and the plurality of transistor channels are respectively isolated from each other.

## Description

### TECHNICAL FIELD

The present disclosure relates to a transistor array for a dynamic random access memory (DRAM) or other semiconductor memory. The disclosure particularly presents a vertical oxide-semiconductor based transistor array, wherein oxide-semiconductor transistor channels of the transistors are respectively isolated from another.

### BACKGROUND

DRAM is a type of semiconductor memory, which is commonly used in various digital electronics, including computers and mobile devices. The memory cells in a DRAM comprise capacitors, which are arranged in an array of rows and columns, wherein each capacitor is configured to store a single bit of information. Each memory cell also comprises a transistor, which is used to read and write data to the capacitor of the memory cell. These transistors may form a transistor array. Such a transistor array may also be used in other kinds of semiconductor memory.

A planar DRAM uses a flat, two-dimensional structure for implementing the memory cells, with a single (planar) transistor and capacitor per memory cell. Planar DRAM has only limited scalability, and while scaling still keeps going on in industry, it is costly, slow, and final limitations are seen beyond 10 nm.

Accordingly, technological effort has been made to develop different DRAM architectures, for example, three-dimensional (3D) DRAM with the potential to increase memory density and capacity. In particular, stacking of memory cells in a DRAM may allow periphery to be placed under the memory cell array, and may thus help to increase die density significantly.

A goal of all DRAM technology advancements is to achieve a 4F2 cell size. 4F2 is the theoretical limit in memory cell size in a DRAM, and means that four DRAM cells are packed into the same area that currently holds two memory cells, while the same level of performance and reliability is maintained. Achieving such a 4F2 cell size is very challenging, as it requires significant advancements in semiconductor manufacturing technology.

Other challenges of conventional DRAM include the so-called row-hammer and pass-gate issues, which may affect the reliability and security of the DRAM. Row-hammer can cause bit flips in adjacent memory cells of the DRAM, while pass-gate issues can lead to data corruption and system crashes. Row-hammer and pass-gate issues may be caused by recessed gate structures in the DRAM, and are expected to become unsustainable at or below the 11 nm process node.

Another challenge is that conventional silicon-based transistors used in a DRAM have a non-negligible off-state current, which may lead to an increased power consumption and the need for faster refresh rates of the memory cells.

### SUMMARY

This disclosure has the objective to address the above-mentioned challenges, and to provide an improved DRAM or other semiconductor memory. A particular objective is to provide a transistor array for the DRAM or other semiconductor memory, which enables a stackable memory cell structure. Other objectives are that the transistor array is back end of line (BEOL) compatible, has an ultra-low off-state power, and allows placing periphery under the memory cell array, in order to possibly reach a 4F2 memory cell size.

These and other objectives are achieved by the solutions of this disclosure as described in the independent claims. Advantageous implementations are described in the dependent claims.

A first aspect of this disclosure provides a transistor array for a DRAM, the transistor array comprising: a substrate layer; a plurality of vertical transistors formed above the substrate; wherein each vertical transistor comprises a first contact and a second contact, which are arranged one above the other at different distances from a surface of the substrate layer, and a transistor channel that connects the first and the second contact; wherein each transistor channel comprises an oxide-semiconductor material; and wherein the plurality of transistor channels of the plurality of vertical transistors are respectively isolated from each other.

Each vertical transistor of the transistor array may be connectable to a capacitor or capacitor structure, in order to form a memory cell in a DRAM. The transistor array and a plurality of capacitors may thus form a memory cell array. The vertical transistors of the transistor array may be field effect transistors (FETs), and may control the access to the capacitors. Thus, the vertical transistors may be configured to act as select transistors to the capacitors that are used to store the information bits.

The vertical oxide-semiconductor transistor array of the first aspect, with its isolated transistor channels, may solve the aforementioned challenges of the conventional DRAM approaches in the following ways. The transistor array may be a three-dimensional (3D) transistor array, which may be used to form a 3D memory array, wherein multiple vertical transistors are arranged respectively along all three axis of a Cartesian coordinate system.

Firstly, the vertical configuration of the transistors may improve scalability by transposing critical length scales (e.g. gate-length, contact-pitch, etc.) to the vertical direction, which is conventionally not utilized (e.g., in a planar DRAM). The vertical configuration may be achieved by depositing layers with a highly controllable thickness, rather than the complicated, costly, and in many cases unreachable, route of patterning.

Secondly, the isolation of the transistor channels from each other outside of the substrate layer (e.g., comprising a bulk of silicon) may reduce wandering charge(s). This may reduce or remove the row-hammer and pass-gate issues.

Thirdly, since the transistors channels comprises the oxide-semiconductor material, the transistors channels may have an ultra-low off-state current.

In an implementation of the transistor array, each vertical transistor further comprises a gate contact, which is arranged between the source contact and the drain contact and is at least partly surrounded by the transistor channel of the vertical transistor.

In an implementation of the transistor array, each vertical transistor comprises a gate insulation, which at least partly surrounds the gate contact and is at least partly surrounded by the transistor channel of the vertical transistor.

According to the above implementations, the vertical transistors may be vertical FETs.

In an implementation of the transistor array, the oxide-semiconductor material of each transistor channel comprises or consists of at least one of the following: indium gallium zinc oxide (IGZO); indium tin oxide (ITO); indium zinc oxide (IZO); indium aluminum zinc oxide (IAZO); indium gallium oxide (IGO); indium gallium zinc silicon oxide (IGZSO); indium magnesium zinc oxide (IMZO).

These oxide-semiconductor materials may lead to an ultra-low off-state current of the vertical transistors.

In an implementation of the transistor array, the plurality of transistor channels are respectively isolated from each other by silicon nitride material or a dielectric material.

This material provides good isolation, is not costly, and easy to deposit. A particular advantage of silicon nitride is that the oxide-semiconductor material of the transistor channels does not deposit on the silicon nitride, which may be beneficial during fabrication of the transistor array.

In an implementation, the transistor array further comprises: a plurality of bit-lines; wherein each bit line is arranged on the substrate layer; and wherein a different set of first contacts of the plurality of first contacts of the plurality of vertical transistors is arranged on each bit-line.

In an implementation, the transistor array further comprises: a plurality of bit-lines; wherein each bit-line is formed by a set of integrally formed first contacts of the plurality of first contacts of the plurality of vertical transistors.

In an implementation, the transistor array further comprises: a plurality of word-lines; wherein each word-line is connected to or formed integrally with a different set of gate contacts of the plurality of gate contacts of the plurality of vertical transistors.

The bit-lines and word-lines may be arranged in a crossed pattern, so as to implement a cross-bar array. Each vertical transistor is connected to one bit-line and one word-line.

A second aspect of this disclosure provides a semiconductor memory device, for example a DRAM, comprising: at least one transistor array according to one of the first aspect or any implementation of the first aspect; wherein each memory cell of the semiconductor memory device comprises one vertical transistor of the plurality of vertical transistors of the at least one transistor array.

In a DRAM, the bit-lines and word-lines may run orthogonal to each other, and each transistor of the transistor array - along with the storage capacitor of the memory cell connected to a free contact of the transistor of that memory cell - lies in a junction of one bit-lines and word-line. That is, the DRAM may have a cross-bar cell array.

The semiconductor memory device of the second aspect has an improved performance, due to the transistor array of the first aspect. For instance, it shows a lower off-state current, and no or less row-hammer and pass-gate effects. Moreover, the semiconductor memory device may be a 3D memory device, for instance, a 3D DRAM, and may have vertical and/or stacked memory cells. The memory device thus has improved scalability. A 4F2 cell size is achievable.

A third aspect of this disclosure provides a method for fabricating a transistor array for DRAM, the method comprising: forming a substrate layer; forming a plurality of vertical transistors above the substrate layer; wherein each vertical transistor comprises a first contact and a second contact, which are formed one above the other at different distances from a surface of the substrate layer, and a transistor channel formed to connect the first and the second contact; wherein each transistor channel comprises an oxide-semiconductor material; and wherein the plurality of transistor channels of the plurality of vertical transistors are respectively isolated from each other.

In an implementation, the method comprises: forming a layer structure above the substrate layer, the layer structure including a first contact layer, a sacrificial layer formed on the first contact layer, and a second contact layer formed on the sacrificial layer; separating the layer structure into a plurality of blocks by forming a plurality of trenches in the layer structure, wherein each block comprises a part of the first contact layer, a part of the second contact layer, and a part of the sacrificial layer in between the first and the second contact layer parts; filling the trenches with a dielectric material; forming a gap in each block by removing the sacrificial layer part in the block; and forming one of the transistor channels in each block by depositing the oxide-semiconductor material into the gap; wherein the plurality of transistor channels are respectively isolated from each other by the dielectric material.

This implementation produces a first configuration of the vertical transistors (design A).

In an implementation, the method comprises: forming a first contact layer above the substrate layer; separating the first contact layer into a plurality of ridges by forming a plurality of first trenches in the first contact layer and filling the first trenches with a first silicon nitride material; forming a sacrificial layer on the separated first contact layer and forming a second contact layer on the sacrificial layer; separating the sacrificial layer and the second contact layer by forming a plurality of second trenches aligned with the first silicon nitride material and filling the second trenches with a first dielectric material and with a second silicon nitride material formed on the first dielectric material; forming a plurality of third trenches perpendicular to the second trenches and through the first contact layer, second contact layer and sacrificial layer; and filling the third trenches with a third silicon nitride material; partially removing the sacrificial layer, completely removing the first dielectric material, and depositing oxide-semiconductor material to where the sacrificial layer was partially removed; wherein the oxide-semiconductor material forms the plurality of transistor channels and the plurality of transistor channels are respectively isolated from each other by the first, second and third silicon nitride material and the sacrificial material.

This implementation produces a second configuration of the vertical transistors (design B).

In an implementation, the method comprises: forming a layer structure above the substrate layer, the layer structure including a first contact layer, a sacrificial layer formed on the first contact layer, and a second contact layer formed on the sacrificial layer; separating the layer structure into a plurality of blocks by forming a plurality of first trenches and a plurality of second trenches perpendicular to the first trenches in the layer structure, and filling the first and the second trenches with a dielectric material; forming a plurality of third trenches parallel to the second trenches, wherein each third trench is formed in between two of the second trenches; forming a plurality of gaps by removing the sacrificial layer; and forming the plurality of transistor channels by depositing the oxide-semiconductor material into the gaps; wherein the plurality of transistor channels are respectively isolated from each other by the dielectric material.

This implementation produces a third configuration of the vertical transistors (design C).

In an implementation of the method, during the deposition of the oxide-semiconductor material, the oxide-semiconductor material does not deposit on any silicon nitride material.

The method of the third aspect achieves the same advantages as the transistor array of the first aspect and may be extended by respective implementations as described above for the transistor array of the first aspect.

The method of the third aspect implements different process flows for fabricating the vertical transistor array, and may be part of a process for fabricating a 3D DRAM or other semiconductor memory.

### BRIEF DESCRIPTION OF THE DRAWINGS

The above described aspects and implementations are explained in the following description of embodiments with respect to the enclosed drawings:
- FIG. 1: shows a transistor array according to this disclosure.
- FIG. 2: shows memory cells according to this disclosure, each including a transistor and a capacitor, for a DRAM.
- FIG. 3: shows three different configurations (designs A, B, and C) for a vertical transistor of a transistor array according to this disclosure.
- FIG. 4: shows transistor arrays according to this disclosure for the three different configurations of the vertical transistor.
- FIG. 5: shows a flow-diagram of a method suitable for fabricating a transistor array according to this disclosure.
- FIG. 6: shows a process flow for a first configuration (design A) of a vertical transistor of a transistor array according to this disclosure.
- FIG. 7: shows a process flow for a second configuration (design B) of a vertical transistor of a transistor array according to this disclosure.
- FIG. 8: shows a process flow for a third configuration (design C) of a vertical transistor of a transistor array according to this disclosure.

### DETAILED DESCRIPTION OF EMBODIMENTS

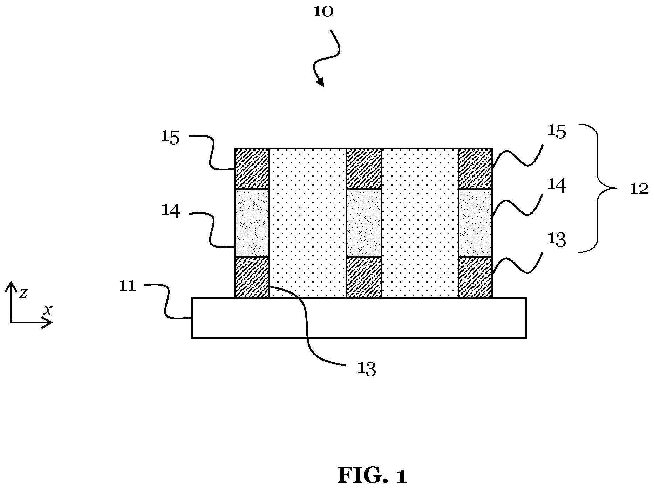

FIG. 1 shows a transistor array 10 according to this disclosure. The transistor array 10 is suitable for being used in a DRAM. In the DRAM, the transistor array 10 can form a memory cell array together with a plurality of capacitors, wherein a bit of information can be respectively stored in each capacitor. The transistor array 10 may be connected to the capacitor array in the DRAM. Each transistor of the transistor array 10 may thereby be connected to one of the capacitors, in order to form a memory cell of the DRAM. The transistors of the transistor array 10 may function as select transistors to access the capacitors. Notably, the transistor array 10 of this disclosure may also be used in a different kind of semiconductor memory.

As shown in FIG. 1, the transistor array 10 comprises a substrate layer 11, which may comprise silicon or a silicon-based material. The substrate layer 11 may be a bulk of silicon or silicon-based material.

The transistor array 10 further comprises a plurality of vertical transistors 12, which are respectively formed above the substrate layer 11. That means, the vertical transistors 12 may be formed either directly on the substrate layer 11 (as illustrated in FIG. 1), or with at least one layer arranged in between the substrate layer 11 and the vertical transistors 12.

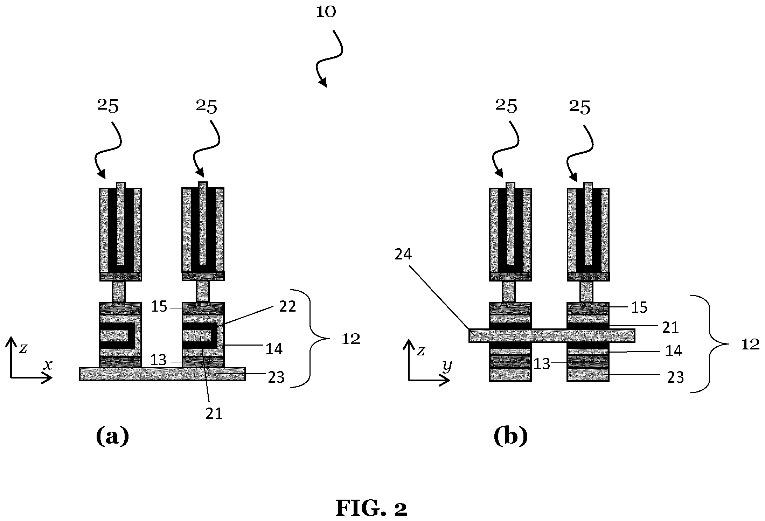

In FIG. 1, the vertical direction that defines the vertical transistors is along the z-axis, and this z-axis may also define, whether an element of the transistor array 10 is arranged "above" or "below" another element. The z-axis may be perpendicular to the plane of the substrate layer 11, and may thus correspond to a distance to the substrate layer 11. That is, an element further away from the substrate layer 11 is arranged "above" another element that is closer to the substrate layer 11. FIG. 1 also shows the x-axis, which is perpendicular to the z-axis, and along which multiple vertical transistors 12 are arranged. The transistor array 10 may, for instance, comprise transistors 12 arranged in columns and rows, and the x-axis may correspond to the arrangement of the columns. Further a y-axis, which may correspond to the arrangement of the rows, is directed into the plane in FIG. 1. The y-axis is not shown in FIG. 1, but is shown, for instance, in FIG. 2.

Each vertical transistor 12 of the plurality of vertical transistors 12 comprises a first contact 13, a second contact 15, and a transistor channel 14 that connects the first contact 13 and the second contact 15. The first contact 13 and the second contact 15 are arranged one above the other at different distances from a surface of the substrate layer 11, which leads to the vertical configuration of the transistors 12. The first contact 13 may be arranged directly on the substrate layer 11 (as shown in FIG. 1), or may be arranged on a layer that is directly arranged on the substrate layer 11. Each first contact 13 and second contact 15 may be or comprise at least one metal.

The transistor channel 14 is arranged between the first contact 13 and the second contact 15, and connects these contacts along the vertical direction. However, the transistor channel 14 does not necessarily have to extend itself in a straight, vertical manner, but can have a bent or curved shape. Overall, however, each vertical transistor 12 extends away from the substrate layer 11 along the z-axis.

Each transistor channel 14 comprises an oxide-semiconductor material, i.e., is formed from at least one oxide-semiconductor material. The oxide-semiconductor material can, for example, comprise or be at least one of: IGZO, ITO, IZO, IAZO, IGO, IGZSO, or IMZO. Other similar material are possible. The transistor channels 14 in the transistor array 10 may all comprise the same oxide-semiconductor material.

The plurality of transistor channels 14 of the plurality of vertical transistors 12 are moreover isolated from each other (as indicated for the shown transistor channels 14 by the dotted areas in FIG. 1). That means, each transistor channel 14 is isolated from all the other transistor channels 14, in particular, by being isolated from all its neighboring transistor channels 14 in the transistor array 10. A dielectric material may be used to isolate the transistor channels 14, for example, silicon nitride. For example, the plurality of transistor channels 14 may respectively be isolated from each other by silicon nitride and/or another dielectric material.

FIG. 2 shows a schematic of two neighboring memory cells for a DRAM, which is based on the transistor array 10 of this disclosure. Each memory cell includes a vertical oxide-semiconductor based transistor 12, for example, a FET, and includes a capacitor 25 or other storage means. The memory cells are particularly shown in two cross-sections in FIG. 2. Thereby, FIG. 2(a) shows the z-axis (vertical direction) and the x-axis, while FIG. 2(b) shows the z-axis and the y-axis.

The vertical transistor 12 of each memory cell is connected to the capacitor 25 or other storage means of the memory cell, and may thus function as a select transistor. The transistor 12 and the capacitor 25 or other storage means may be arranged vertically above each other along the z-axis. That is, the capacitor 25 or other storage means may have a larger distance to the substrate layer 11 (or to a bit line 23, on which the vertical transistor 12 is provided, as shown in FIG. 2) than the vertical transistor 12.

Each vertical transistor 12 may further comprise a gate contact 21 (e.g., a gate metal), which is arranged between the first contact 13 and the second contact 15, and which is at least partly surrounded by the transistor channel 14 of the vertical transistor 12. The transistor channel 14 may have a bent and/or a curved shape between the first contact 13 and the second contact 15, for instance, a U-shape as shown in FIG. 2. This shape may partly encircle the gate contact 21. Each vertical transistor 12 may further comprise a gate insulation 22, which is arranged between the gate contact 21 and the transistor channel 12, for instance, a dielectric material such as an oxide or a high-k material. The gate insulation 22 may at least partly surround the gate contact 21, and may be at least partly surrounded by the bent and/or curved transistor channel 14. The gate contact 21, the gate insulation 22, and the transistor channel 14 may form a FET.

The transistor array 10 may further include a plurality of bit-lines 23 and a plurality of word-lines 24. These lines may, for instance, be arranged perpendicular to each other, so as to form a crossed pattern. For instance, they may be arranged in a cross-bar array of a DRAM or other memory. Notably, the bit-lines 23 and word-lines 24 may also be part of a DRAM, which includes the transistor array 10, and not of the transistor array 10 itself. In any case, each vertical transistor 12 of the transistor array 10 may be arranged on and contacted to one of the bit-lines 23. Further, each gate contact 21 may be formed integrally with one of the word-lines 24, or may at least be connected to one of the word-lines 24. The gate contact 21 and the respective word-line 24 may be made of the same material, for instance, a metal.

Advantageously, due to the BEOL compatibility of the solutions of this disclosure, memory cells - each comprising a vertical transistor 12 and capacitor 25 - may also be repeated along the z-axis. That is, a 3D memory array may be formed.

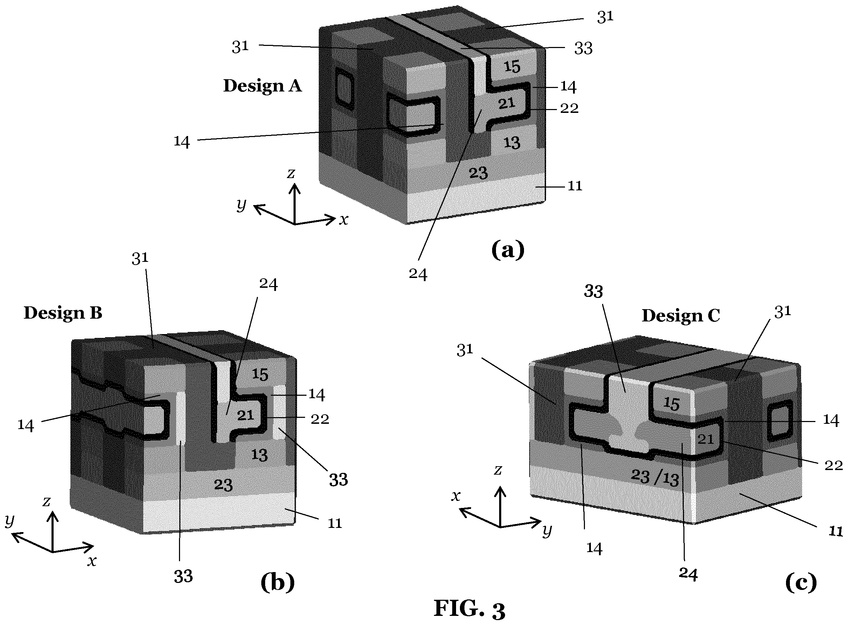

FIG. 3 shows three different exemplary configurations, which are proposed for the transistor array 10 and its vertical transistors 12. In particular, FIG. 3 shows a part of the transistor array 10 that includes neighboring vertical transistors 12, for instance, for neighboring memory cells of a DRAM (the shown parts may be included multiple times in the transistor array 10). FIG. 3(a) shows a first configuration named "Design A", FIG. 3(b) shows a second configuration named "Design B", and FIG. 3(c) shows a third configuration named "Design C".

Each of the exemplary configurations shows that a vertical transistor 12 comprises a first contact 13, a second contact 15, and a transistor channel 14 arranged in between the contacts. Also, FIG. 3 shows that each vertical transistor 12 comprises respectively a gate contacts 21, and a gate insulation 22. Also, a bit-line 23 and a word-line 24 are shown.

In the designs A and B, the bit-line 23 is arranged on the substrate layer 11, and the first contacts 13 of the vertical transistors 12 are arranged on the bit-line 23. In design C, the bit-line 23 and the first contacts 13 of the vertical transistors 12 are formed integrally, i.e., the bit-line 23 and the first contacts 13 (they are part of the bit-line 23) are arranged on the substrate layer 11. In design C, the x-axis and y-axis are notably different than in the designs A and B.

In all three exemplary configurations, the transistor channels 14 are respectively isolated from each other by a silicon nitride material 31 and/or a dielectric material 33 (e.g., silicon oxide).

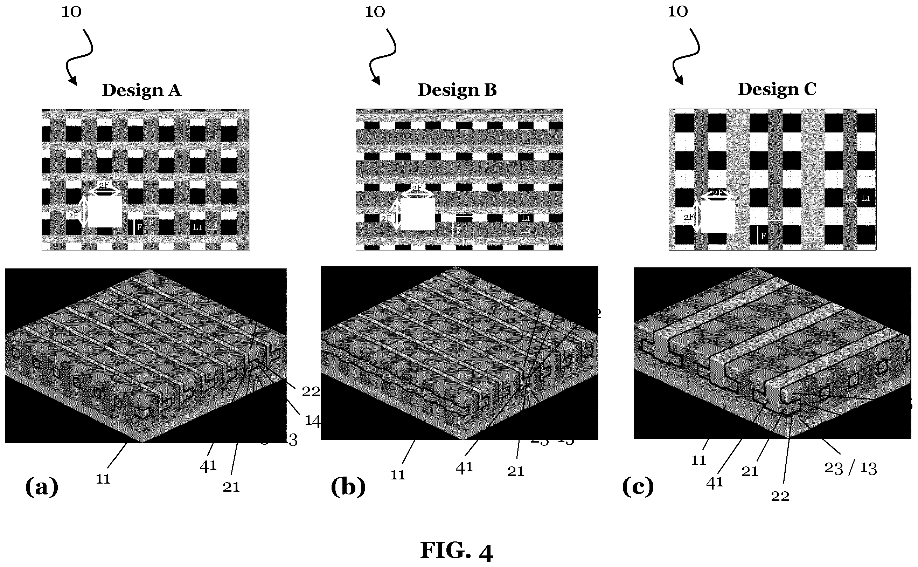

FIG. 4 shows an overview of respective transistors arrays 10 according to the three different configurations (designs A, B, and C) in FIG. 4(a), 4(b), and 4(c), respectively.

Each transistor array 10 comprises a plurality of bit-lines 23 and a plurality of word-lines 24. In designs A and B, each bit line 23 is arranged on the substrate layer 11. A different set of the first contacts 13 of the plurality of first contacts 13 of the plurality of vertical transistors 12 is arranged on each bit-line 23. That is, a first set of the first contacts 13 is arranged on a first bit-line 23, and a second set of the first contacts 13 is arranged on a second bit-line 23, and so on. Each bit-line 23 thus contacts a certain set of vertical transistors 12 of the plurality of vertical transistors 12. In design C, each bit-line 23 is formed integrally by or with a different set of the first contacts 13 of the plurality of first contacts 13 of the plurality of vertical transistors 12. That is, a first set of the first contacts 13 is formed integrally with a first bit-line 23, a second set of the first contacts 13 is formed integrally with a second bit-line 23, and so on. Each bit-line 23 is thus connected to a certain set of vertical transistors 12 of the plurality of vertical transistors 12.

In each of the designs A, B, and C, each word-line 24 is connected to or is formed integrally with a different set of gate contacts 21 of the plurality of gate contacts 21 of the plurality of vertical transistors 12. That is, a first set of gate contacts 21 is connected to or formed integrally with a first word-line 24, a second set of gate contacts 21 is connected to or formed integrally with a second word-line 24, and on. Each word-line 24 is therefore arranged next to a different set of transistor channels 14 of the plurality of transistor channels 14 of the plurality of vertical transistors 12. The word-lines 24 may be buried word-lines 24. As indicated exemplarily in FIG. 4, each transistor channel 14 may comprise or may consist of IGZO as one example of the oxide-semiconductor material.

As shown in FIG. 4, a crossbar-array is formed for each design A, B, and C, wherein each vertical transistor 12 is connected (by its first contact 13) to one bit-line 23, and is connected (by its gate contact 21) to one word-line 24. As can be further seen in FIG, 4, the transistor array 10 can be designed having 4F2 cell sizes for memory cell array of a DRAM.

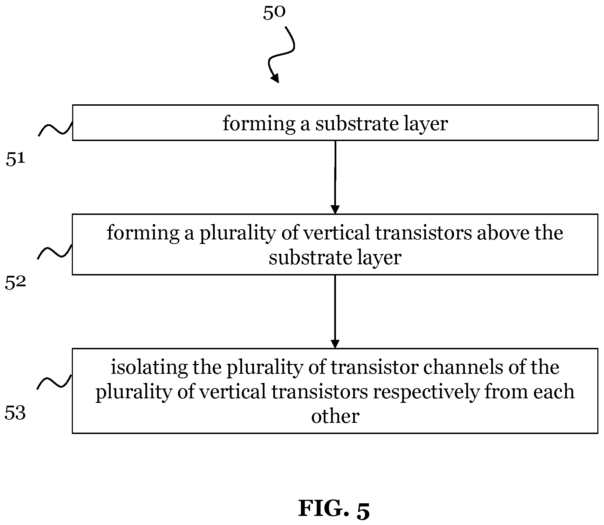

FIG. 5 shows a flow-diagram of a method 50 according to this disclosure, which is suitable for fabricating the transistor array 10. The method 50 generally comprises a step 51 of forming the substrate layer 11, a step 52 of forming 52 the plurality of vertical transistors 12 above the substrate layer 11, and a step 53 of isolating the transistor channels 14. The steps 52 and 53 do not have to be performed in the described order or even strictly one after the other. The process of forming the vertical transistors 12 may include isolating the transistor channels 14.

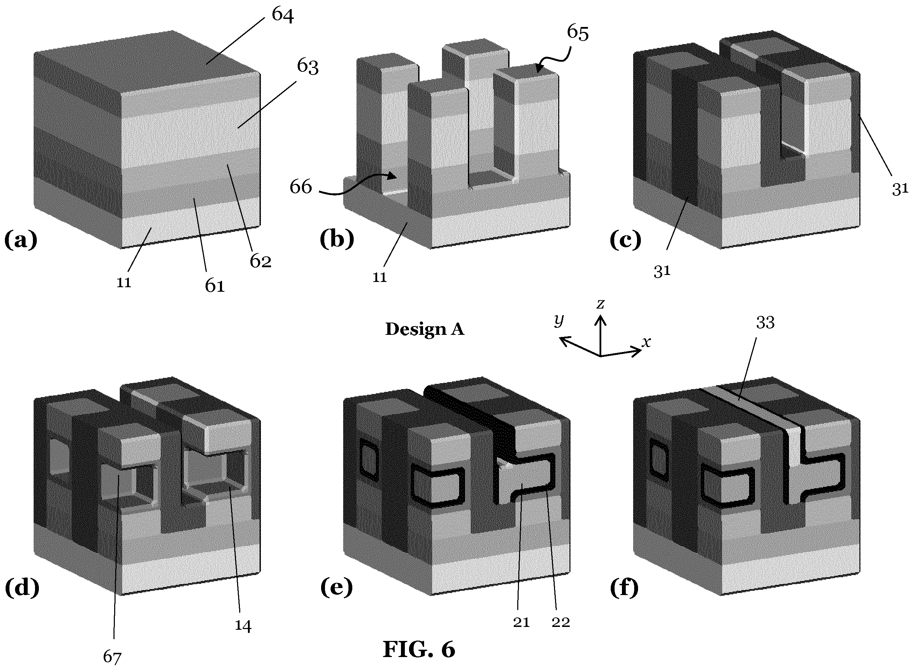

In any case, each vertical transistor 12 is formed to have a first contact 13 and a second contact 15, which are formed one above the other at different distances from a surface of the substrate layer 11, and to have a transistor channel 14 (comprising an oxide-semiconductor material) that is formed to connect the first contact 13 and the second contact 15. The method 50 includes isolating the plurality of transistor channels 14 of the plurality of vertical transistors 12 respectively from each other. Examples are shown in the following FIGs. 6-8.

FIG. 6 shows a first process flow (of the method 50) for fabricating a transistor array 10 according to the first configuration (design A). This exemplary configuration comprises a word-line 24 that connects the buried gate contact 21 of the bit cells.

As shown in FIG. 6(a), the substrate layer 11 is formed, and a layer structure is formed on the substrate layer 11. The layer structure includes a bit-line metal 61, a first contact layer 62 (e.g., first metal layer), a sacrificial layer 63 (e.g., an oxide layer) formed on the first contact layer 62, and a second contact layer 64 (e.g., second metal layer) formed on the sacrificial layer 63. The layers 61, 62, 63 of this layer structure may, for example, be formed by layer deposition (like ALD or chemical vapor deposition or physical vapor deposition).

As shown in FIG. 6(b), the process flow then comprises separating the layer structure into a plurality of blocks 65, which may be done by forming a plurality of trenches 66 in the layer structure. Each block 65 comprises a part of the first contact layer 62, a part of the second contact layer 64, and a part of the sacrificial layer 63 that is in between the parts of the first and the second contact layer 62, 64. Forming the trenches 66 may comprise first lithography (L1 lithography) and metal-oxide-metal etching (of the layers 64, 63 and 62) with an etch stop on the bit-line metal 61. Further, forming the trenches 66 may comprise second lithography (L2 lithography) and metal-oxide-metal-metal etching (of the layers 64, 63, 63 and 61). The etching of the bit-line metal 61 in only the second etching step may define the bit-lines 23.

As shown in FIG. 6(c), the process flow then comprises filling the trenches 66 with a dielectric material. For example, the gaps between the blocks 65 may be filled with silicon nitride 31 as the dielectric material. A third lithography (L3 lithography) is then be performed, which is followed by an anisotropic (e.g., timed) etching of the dielectric material, for example, the silicon nitride 31.

Further, as shown in FIG. 6(d), the process flow then comprises forming a gap 67 in each block 65 by removing the part of the sacrificial layer 63 in the block 65. This may be done by isotropic etching. Further the process flow may comprise forming one of the transistor channels 14 in each of the blocks 65 by depositing the oxide-semiconductor material into the gap 67 followed by an anisotropic etch of the material. For instance, IGZO, as an example for the oxide-semiconductor material, maybe deposited to form the transistor channels 14. The transistor channels 14 are respectively isolated from each other by the dielectric material, for example, the silicon nitride 31.

As shown in FIG. 6(e), the gate contact 21 and gate insulation 22 are then formed. The gate insulation 22 may be deposited into the gap (onto the transistor channel 14), which may be followed by an anisotropic etch. The word-line material may be deposited into the gap 67 (and onto the gate insulation 22), in order to form the gate contact 21. This may be followed by chemical-mechanical polishing (CMP) and an anisotropic (e.g., timed) etch.

As shown in FIG. 6(f), a further dielectric material 33, for instance, silicon oxide, is then deposited into remaining gaps.

Due to the process flow shown in FIG. 6, in the final transistor array 10, the plurality of transistor channels 14 are respectively isolated from each other by the dielectric material 31, for example, the silicon nitride.

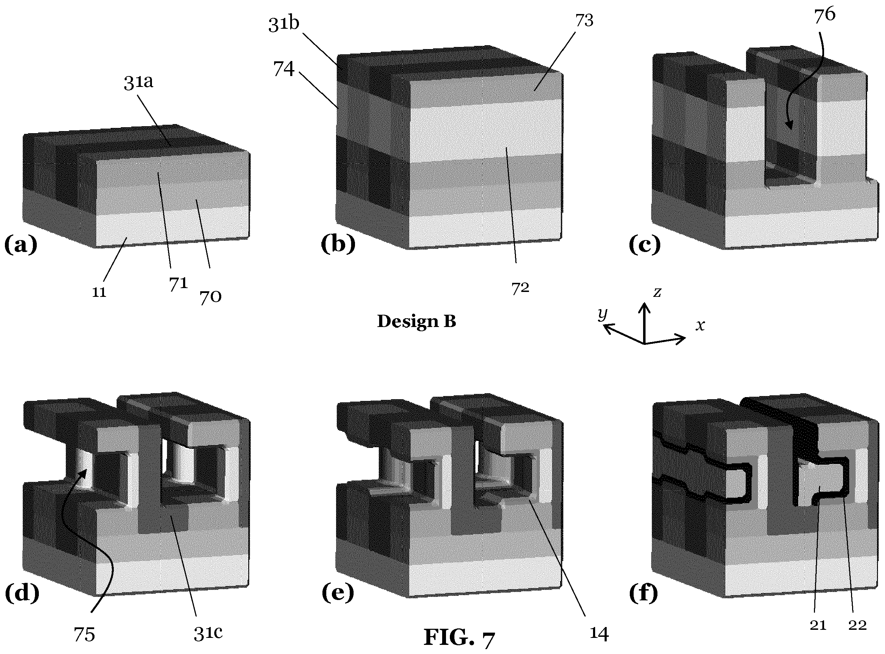

FIG. 7 shows a process flow (of the method 50) for fabricating transistor array 10 according to the second configuration (design B). This configuration comprises area-selective atomic layer deposition (ALD) of oxide-semiconductor channel material.

As shown in FIG. 7(a), the substrate layer 11 is formed, and a first contact layer 71 (e.g., a first metal layer) is formed on a bit-line layer 70 above the substrate layer 11. The first contact layer 71 is separated into a plurality of ridges by forming a plurality of first trenches in the first contact layer 71, and the first trenches are filled with a first silicon nitride material 31a. This may be performed by a first lithography (L1 lithography) and a metal-metal etch (of the layers 71 and 70), and may be followed by a silicon nitride gap/trench fill.

As shown in FIG. 7(b), the process flow further includes forming a sacrificial layer 72 (e.g., an oxide layer) on the separated first contact layer 71, and forming a second contact layer 73 (e.g., second metal layer) on the sacrificial layer 72. The sacrificial layer 72 and the second contact layer 73 are separated by forming a plurality of second trenches aligned with the first silicon nitride material 31b. This may include L1 lithography and metal-oxide etching. Further, the process flow comprises filling the second trenches with a first dielectric material 74 and with a second silicon nitride material 31b, which is formed on the first dielectric material 74. This may be done by a spin-on dielectric deposition and a silicon nitride gap fill.

As shown in FIG. 7(c), the process flow then comprises forming a plurality of third trenches 76, which are perpendicular to the second trenches and are formed through the first contact layer 71, the second contact layer 73, and the sacrificial layer 72. This may comprise second lithography (L2 lithography) and metal-oxide-metal etching (of the layers 73, 72, and 71) and also an etching of the spin-on dielectric 74 and silicon nitride 31a, 31b, down onto the bit-line layer 70.

As shown in FIG. 7(d), the process flow then comprises filling the third trenches 76 with a third silicon nitride material 31c. A third lithography (L3 lithography) is then performed, which is followed by an anisotropic (e.g., timed) etching of the silicon nitride material 31c. Then the process flow comprises partially removing the sacrificial layer 72, and completely removing the first dielectric material 74.

As shown in FIG. 7(e), the process flow further comprises depositing oxide-semiconductor material to where the sacrificial layer 72 was partially removed and onto the contact layers. The oxide-semiconductor material may, for example, be IGZO, and may be selectively deposited (wherein the oxide-semiconductor material does not deposit on silicon nitride). The oxide-semiconductor material forms the plurality of transistor channels 14.

As shown in FIG. 7(f), the process flow further comprises a gate insulation 22 deposition, and anisotropic etch thereof, a word-line metal deposition to form the gate contacts 21, and an anisotropic (e.g., timed) etch thereof, similar as described with respect to FIG. 6(e).

Due to the process flow shown in FIG. 7, in the final transistor array 10, the plurality of transistor channels 14 are respectively isolated from each other by the first, second, and third silicon nitride material 31a, 31b, 31c, and the remains of the sacrificial material 72.

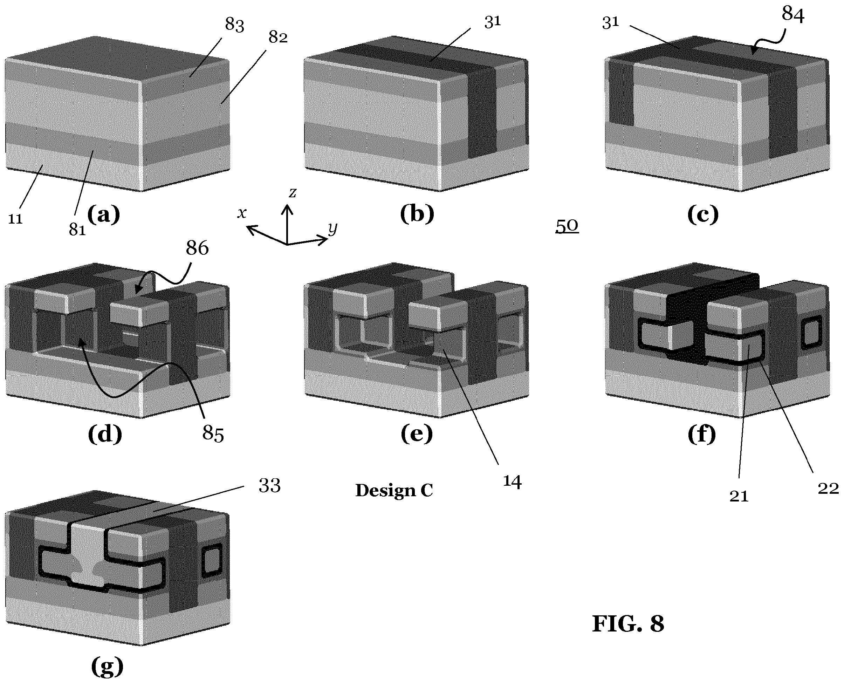

FIG. 8 shows a process flow (of the method 50) for fabricating transistor array 10 according to the third configuration (design C). This configuration has a relaxed patterning density requirement and includes a simple deposition and etch scheme.

As shown in FIG. 8(a), the substrate layer 11 is formed, and a layer structure is formed on the substrate layer 11. The layer structure includes a first contact layer 81 (e.g., a first metal layer), a sacrificial layer 82 (e.g., an oxide layer) formed on the first contact layer 81, and a second contact layer 83 (e.g., a second metal layer), which is formed on the sacrificial layer 82.

As shown in FIG. 8(b), the process flow comprises forming a plurality of first trenches, and filling the first trenches with a dielectric material 31, for instance, with silicon nitride. This may be done by a first lithography (L1 lithography), a metal-oxide-metal etching (of the layers 83, 82, and 81) and a silicon nitride gap fill.

As shown in FIG. 8(c), the process flow then comprises forming a plurality of second trenches perpendicular to the first trenches in the layer structure, and also filling the second trenches with the dielectric material 31. This may be done by a second lithography (L2 lithography), a metal-oxide etching (of the layers 83 and 82) down onto the first contact layer 81, and a silicon nitride gap fill. Accordingly, the layer structure is separated into a plurality of blocks 84.

As shown in FIG. 8(d), the process flow then comprises forming a plurality of third trenches 86 parallel to the second trenches, wherein each third trench 86 is formed in between two of the second trenches. The process flow also comprises forming a plurality of gaps 85 by removing the sacrificial layer 82, which may be done by an oxide recess step.

As shown in FIG. 8(e), the process flow then comprises forming the plurality of transistor channels 14 by depositing the oxide-semiconductor material into the gaps 85. This step may comprises depositing IGZO, and may comprise anisotropic etching of the IGZO to form the transistor channels 14.

As shown in FIG. 8(f), the process flow further comprises a gate insulation 22 deposition, and anisotropic etch thereof, a word-line metal deposition to form the gate contacts 21, and an anisotropic (e.g., timed) etch thereof, similar as described with respect to FIG. 6(e) or 7(f).

As shown in FIG. 8(g), the process flow also comprise filling a second dielectric material 33, for example, an oxide, into remaining gaps. This may be done by an oxide gap-fill process.

Due to the process flow shown in FIG. 8, in the final transistor array 10, the plurality of transistor channels 14 are respectively isolated from each other by the dielectric material 31, for example, silicon nitride.

In summary, three different process flows are proposed to fabricate a vertical transistor array 10 (e.g., FET array) with isolated oxide-semiconductor channels 14. The transistor array 10 may have high-density and low-power, and may be a selector transistor array for a memory, like a DRAM. The transistor array 10 shows reduced or even no row-hammer and pass-gate issues. The transistor array 10 paves the way for making 3D stackable DRAM, and can provide the same impetus to the DRAM landscape as 3D-NAND did to the NAND-flash type storage-class memory.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A transistor array (10) for a dynamic random access memory, DRAM, the transistor array (10) comprising:
a substrate layer (11);
a plurality of vertical transistors (12) formed above the substrate layer (11);
wherein each vertical transistor (12) comprises a first contact (13) and a second contact (15), which are arranged one above the other at different distances from a surface of the substrate layer (11), and a transistor channel (14) that connects the first contact (13) and the second contact (15);
wherein each transistor channel (14) comprises an oxide-semiconductor material; and
wherein the plurality of transistor channels (14) of the plurality of vertical transistors (12) are respectively isolated from each other.

2. The transistor array (10) according to claim 1, wherein each vertical transistor (12) further comprises a gate contact (21), which is arranged between the first contact (13) and the second contact (15) and is at least partly surrounded by the transistor channel (14) of the vertical transistor (12).

3. The transistor array (10) according to claim 2, wherein each vertical transistor (12) comprises a gate insulation (22), which at least partly surrounds the gate contact (21) and is at least partly surrounded by the transistor channel (14) of the vertical transistor (12).

4. The transistor array (10) according to one of the claims 1 to 3, wherein the oxide-semiconductor material of each transistor channel (14) comprises or consists of at least one of the following:
indium gallium zinc oxide, IGZO;
indium tin oxide, ITO;
indium zinc oxide, IZO;
indium aluminum zinc oxide, IAZO;
indium gallium oxide, IGO;
indium gallium zinc silicon oxide, IGZSO;
indium magnesium zinc oxide.

5. The transistor array (10) according to one of the claims 1 to 4, wherein the plurality of transistor channels (14) are respectively isolated from each other by silicon nitride material (31) or a dielectric material (33).

6. The transistor array (10) according to one of the claims 1 to 5, further comprising:
a plurality of bit-lines (23);
wherein each bit line (23) is arranged on the substrate layer (11); and
wherein a different set of first contacts (13) of the plurality of first contacts (13) of the plurality of vertical transistors (12) is arranged on each bit-line (23).

7. The transistor array (10) according to one of the claims 1 to 5, further comprising:
a plurality of bit-lines (23);
wherein each bit-line (23) is formed by a set of integrally formed first contacts (13) of the plurality of first contacts (13) of the plurality of vertical transistors (12).

8. The transistor array (10) according to one of the claims 2 to 7, further comprising:
a plurality of word-lines (24);
wherein each word-line (24) is connected to or formed integrally with a different set of gate contacts (21) of the plurality of gate contacts (21) of the plurality of vertical transistors (12).

9. The transistor array (10) according to one of the claims 1 to 8, further comprising:
a plurality of word-lines (24);
wherein a different set of transistor channels (14) of the plurality of transistor channels (14) of the plurality of vertical transistors (12) is arranged next to each word-line (24).

10. A semiconductor memory device, for example a dynamic random access memory, DRAM, comprising:
at least one transistor array (10) according to one of the claims 1 to 9;
wherein each memory cell of the semiconductor memory device comprises one vertical transistor (12) of the plurality of vertical transistors (12) of the at least one transistor array (10).

11. A method (50) for fabricating a transistor array (10) for a dynamic random access memory, DRAM, the method (50) comprising:
forming (51) a substrate layer (11);
forming (52) a plurality of vertical transistors (12) above the substrate layer (11);
wherein each vertical transistor (12) comprises a first contact (13) and a second contact (15), which are formed one above the other at different distances from a surface of the substrate layer (11), and a transistor channel (14) formed to connect the first and the second contact (13, 15);
wherein each transistor channel (14) comprises an oxide-semiconductor material; and
wherein the plurality of transistor channels (14) of the plurality of vertical transistors (12) are respectively isolated from each other.

12. The method (50) according to claim 11, comprising:
forming a layer structure above the substrate layer (11), the layer structure including a first contact layer (62), a sacrificial layer (63) formed on the first contact layer (61), and a second contact layer (64) formed on the sacrificial layer (63);
separating the layer structure (62, 63, 64) into a plurality of blocks (65) by forming a plurality of trenches (66) in the layer structure, wherein each block (65) comprises a part of the first contact layer (62), a part of the second contact layer (64), and a part of the sacrificial layer (63) in between the first and the second contact layer (62, 64) parts;
filling the trenches (66) with a dielectric material (31);
forming a gap (67) in each block (65) by removing the sacrificial layer (64) part in the block (65); and
forming one of the transistor channels (14) in each block (65) by depositing the oxide-semiconductor material into the gap (67);
wherein the plurality of transistor channels (14) are respectively isolated from each other by the dielectric material (31).

13. The method (50) according to claim 11, comprising:
forming a first contact layer (71) above the substrate layer (11);
separating the first contact layer (71) into a plurality of ridges by forming a plurality of first trenches in the first contact layer (71) and filling the first trenches with a first silicon nitride material (31a);
forming a sacrificial layer (72) on the separated first contact layer (71) and forming a second contact layer (73) on the sacrificial layer (72);
separating the sacrificial layer (72) and the second contact layer (73) by forming a plurality of second trenches aligned with the first silicon nitride material (31b) and filling the second trenches with a first dielectric material (74) and with a second silicon nitride material (31b) formed on the first dielectric material (74);
forming a plurality of third trenches (76) perpendicular to the second trenches and through the first contact layer (71), second contact layer (73) and sacrificial layer (72); and
filling the third trenches (76) with a third silicon nitride material (31c);
partially removing the sacrificial layer (72), completely removing the first dielectric material (74), and depositing oxide-semiconductor material to where the sacrificial layer (72) was partially removed;
wherein the oxide-semiconductor material forms the plurality of transistor channels (14) and the plurality of transistor channels (14) are respectively isolated from each other by the first, second and third silicon nitride material (31a, 31b, 31c) and the sacrificial material (72).

14. The method (50) according to claim 11, comprising:
forming a layer structure above the substrate layer (11), the layer structure including a first contact layer (81), a sacrificial layer (82) formed on the first contact layer (81), and a second contact layer (83) formed on the sacrificial layer (82);
separating the layer structure into a plurality of blocks (84) by forming a plurality of first trenches and a plurality of second trenches perpendicular to the first trenches in the layer structure (81, 82, 83), and filling the first and the second trenches with a dielectric material (31);
forming a plurality of third trenches (86) parallel to the second trenches, wherein each third trench (86) is formed in between two of the second trenches;
forming a plurality of gaps (85) by removing the sacrificial layer (82); and
forming the plurality of transistor channels (14) by depositing the oxide-semiconductor material into the gaps (85);
wherein the plurality of transistor channels (14) are respectively isolated from each other by the dielectric material (31).

15. The method (50) according to claim 13, wherein during the deposition of the oxide-semiconductor material, the oxide-semiconductor material does not deposit on any silicon nitride material (31).
